# EUROPÄISCHE PATENTSCHRIFT

(11) **EP 2 048 378 B1**
(45) Veröffentlichungstag und Bekanntmachung des Hinweises auf die Patenterteilung: **06.11.2013**
(21) Anmeldenummer: 08105336.5
(22) Anmeldetag: 12.09.2008
(51) Int. Cl.: F16B 5/06

(54) **Rastelement sowie Verrastungsanordnung**
Catch element and catch assembly
Elément d'encliquetage et dispositif à cliquet

(30) Priorität: 08.10.2007 DE 102007048245
(43) Veröffentlichungstag der Anmeldung: 15.04.2009
(73) Patentinhaber: BSH Bosch und Siemens Hausgeräte GmbH, 81739 München (DE)
(72) Erfinder: Geis, Marko, 97640 Oberstreu (DE); Husnik, Stephan, 98646 Hildburghausen (DE); Kastner, Julian, 97656 Oberelsbach (DE); Mischur, Alberto, 07557 Hundhaupten (DE)

(56) Entgegenhaltungen:
- EP-A1- 0 574 284
- GB-A- 1 005 527
- US-A- 3 213 189
- US-A1- 2005 124 202
- US-A1- 2006 042 043

## Beschreibung

Die Erfindung betrifft ein Rastelement sowie eine Verrastungsanordnung nach dem Oberbegriff des unabhängigen Anspruchs.

Vorrichtungen zum lösbaren Verrasten zweier Bauteile sind vielfach bekannt. Üblicherweise weist dabei ein Bauteil ein Rastelement auf, das in ein korrespondierendes Gegenrastelement des anderen Bauteils eingebracht wird. Das Rastelement kann beispielsweise als Clips oder Haken ausgebildet sein, welche entsprechend dimensioniert und biegsam ausgebildet sind, um eine Verbindung zwischen den zwei zu verbindenden Bauteilen zu ermöglichen.

Gerade bei Haushaltsgeräten ist es oft erforderlich, dass die Verrastung möglichst leicht von Hand herstellbar ist und dabei genügend Sicherheit für einen festen Halt bietet. Gleichzeitig soll die Verrastung wieder leicht lösbar sein. Der sichere Halt ist abhängig von der Dimensionierung des Rastelements bzw. der Höhe der Hinterschneidung der zu montierenden Bauteile. Bei einer geringeren Hinterschneidung ist die Haltkraft der Verrastung stark beeinträchtigt, da das Rastelement das zu verbindende andere Bauteil nur noch geringfügig hintergreift. Je größer die Hinterschneidung ist und je unflexibler das Rastelement ausgebildet ist, desto stabiler ist die Verrastung für einen sicheren Halt. Dies bedeutet zugleich, dass für die Handmontage ein höherer Kraftaufwand erforderlich ist, welcher aber nur bis zu einem gewissen Grad möglich ist.

Problematisch bei den üblichen Rastelementen sind Missbrauchskräfte, die beispielsweise durch elektronische Bauteile in Haushaltsgeräten hervorgerufen werden können. Derartige Missbrauchskräfte sind oft um ein vielfaches höher als die normalen zur Montage und Bedienung üblichen Kräfte.

Die Druckschrift US 3,213,189 offenbart eine Befestigungsvorrichtung für einen Kipp- oder Federschalter. Die Befestigungsvorrichtung sieht einen kreisrunden Clip oder eine Klemme vor, die einen federnden Widerhaken aufweist. Der Widerhaken verrastet dann bei der Montage mit einem Gehäuse.

Die Druckschrift EP 0 574 284 A1 beschreibt einen Behälter mit einem Deckel und einem Boden mit einem Verschluss, bestehend aus einem Haken und einem Gegenhaken, die zum Verschließen des Behälters miteinander interagieren. Der Haken ist aus Kunststoff und einstückig mit dem Deckel ausgebildet.

Die Druckschrift US2005/124202 A1 offenbart einen elektrischen Stecker oder eine Buchse mit Rasthaken, die an den Enden von flexiblen Verriegelungsarmen angeordnet sind. An einem Gehäuse sind den Verriegelungsarmen angepasste Rastmulden vorgesehen, so dass die Verriegelungsarme im montierten Zustand an dem Gehäuse einrasten können.

Der Erfindung liegt die Aufgabe zugrunde, ein Rastelement sowie eine Verrastungsanordnung der eingangs genannten Art so weiterzubilden, dass eine leichte Handmontage ermöglicht wird, gleichzeitig jedoch eine stabile Rastverbindung zweier Körper ermöglicht wird, die nach einer Handmontage selbst unter großer Kraftanwendung nicht mehr lösbar ist.

Diese Aufgabe wird erfindungsgemäß mit den Merkmalen des unabhängigen Anspruchs gelöst. Vorteilhafte Weiterbildungen ergeben sich aus den Merkmalen der Unteransprüche.

Bei einem erfindungsgemäßen Rastelement zur Verbindung eines ersten Körpers mit einem zweiten Körper, insbesondere eines Haushaltsgeräts, ist rastelementseitig eine Rastzunge mit einem Widerhaken vorgesehen, wobei der Widerhaken verschwenkbar an der Rastzunge angelenkt ist.

Wird das Rastelement in Wirkverbindung mit den korrespondierend ausgebildeten Gegenelementen des zu verbindenden zweiten Körpers gebracht, funktioniert die Sicherung der Verrastung vorteilhafterweise nach dem Prinzip einer selbsttätigen Sperre, die bei der Montage selbsttätig ausgelöst wird. Der sperrende Teil dieser Sicherung ist bevorzugt als Widerhaken ausgebildet, der in einem längsgerichteten Durchbruch der Rastzunge angeordnet ist und erst im Augenblick der Endstellung der zu verbindenden zwei Körper seine Sperrwirkung entfaltet. Als erster Körper ist dabei bevorzugt ein mit dem Rastelement verbundenes Einbauelement eines Haushaltsgeräts vorgesehen, insbesondere eines Bodenstaubsaugers, und der zweite Körper ist als Gehäuseteil des Bodenstaubsaugers ausgebildet.

Der Widerhaken ist mit seinem ersten Ende fest mit der Rastzunge verbunden und mit seinem gegenüberliegenden zweiten Ende bewegbar. Das erste Ende des Widerhakens ist in einem Bereich mit der Rastzunge verbunden, in dem eine Rastnase ausgebildet ist. Die Rastnase kann dabei als Vorsprung ausgebildet sein, der über die Oberfläche des Rastelements übersteht.

Erfindungsgemäß steht der Widerhaken mit einer Außenfläche zumindest bereichsweise über eine Oberfläche der Rastzunge über, wobei die Rastnase an der Oberfläche ausgebildet ist, so dass der Widerhaken über Krafteinwirkung auf seine überstehende Außenfläche mit seinem zweiten Ende auf die der Rastnase gegenüberliegende Seite der Rastzunge schwenkbar ist. Die Verschwenkbarkeit des Widerhakens wird zweckmäßigerweise durch seine Fertigung aus einem elastischen Material verstärkt, wodurch der Widerhaken bis zu einem gewissen Grad gebogen werden kann. Günstigerweise weist der Widerhaken an seinem ersten Ende einen geringeren Querschnitt auf als an seinem zweiten Ende. Dadurch wird vorteilhafterweise eine Verformungsrichtung des Widerhakens während des Montagevorgangs vorgegeben bzw. die Verschwenkbarkeit des Widerhakens erleichtert.

Insgesamt erweist sich diese Ausgestaltung insbesondere bei der Handmontage als vorteilhaft, wobei die Verrastung selbsttätig auslösbar ist.

Eine erfindungsgemäße Verrastunganordnung geht aus von einem Rastelement der oben beschriebenen Art, einem mit dem Rastelement verbundenen ersten Körper sowie einem zweiten Körper, wobei der erste Körper insbesondere als Einbauelement eines Bodenstaubsaugers ausgebildet ist, und der zweite Körper als Gehäuseteil. Erfindungsgemäß ist das Rastelement zusammen mit dem Einbauelement in seiner montierten Stellung mit dem Gehäuseteil so in einer Schließstellung selbsttätig versperrbar, dass die Rastnase des Rastelements mit einem am Gehäuseteil ausgebildeten Gegenrastelement zusammenwirkt und der Widerhaken mit einem freien Ende mit einem korrespondierenden Element des Gehäuseteils verrastet ist.

Im Montagezustand sind die Rastnase und das freie Ende des Widerhakens auf gegenüberliegenden Seiten des Rastelements angeordnet. Das korrespondierende Element des Gehäuseteils ist zweckmäßigerweise als Vertiefung ausgebildet, in welche der Widerhaken mit seinem zweiten freien Ende eingreift. Mit seinem zweiten freien Ende wird der Widerhaken während des Montagevorgangs durch Krafteinwirkung des Gegenrastelements in das korrespondierende Element des Gehäuseteils verklemmt.

Vorteilhafterweise wird dadurch vorteilhafterweise eine doppelte Sperrwirkung entfaltet, nämlich einerseits über die Rastnase, die mit dem Gegenrastelement des Gehäuseteils zusammenwirkt, und andererseits über das zweite freie Ende des Widerhakens, das in einer korrespondierenden Ausnehmung des Gehäuseteils verklemmt. Beide Sperrwirkungen werden vorteilhafterweise selbsttätig während des Montagevorgangs ausgelöst, ohne dass zusätzliche Arbeitsschritte bei der Montage erforderlich sind. Vorteilhafterweise ist eine Handmontage möglich, so dass sich der Einsatz von Werkzeugen erübrig. Der zu befestigende Körper ist auch unter großer Kraftanwendung nicht mehr lösbar. Insofern ist die vorgeschlagene Lösung beispielsweise mit einem Wanddübel oder einem Maueranker vergleichbar.

Als weiterer wesentlicher Vorteil der vorgeschlagenen Lösung kommt hinzu, dass keine zusätzlichen Elemente verbaut bzw. montiert werden müssen. Außerdem muss günstigerweise die aufzubringende Montagekraft nicht gegenüber herkömmlichen Rastverbindungen erhöht werden. Als weiterer Vorteil kommt hinzu, dass die vorgeschlagene Lösung eine stabile Verrastung bietet, die selbst unter Einwirkung von Missbrauchskräften Schutz gegen ungewolltes Lösen bietet. Diese Sicherung kann somit insbesondere dort angewendet werden, wo vorwiegend eine Handmontage erfolgt, wo die Entformungsrichtung der Rasthaken werkzeugtechnisch fixiert ist, und wo eine spielfreie Verrastung notwendig ist und daher die Anwendung abgeschrägter, bei Krafteinwirkung sich selbst spreizender Rasthaken nicht möglich ist.

Anhand von in der Zeichnung dargestellten Ausführungsbeispielen wird die Erfindung nachfolgend näher beschrieben. Es zeigt:
- Fig. 1: eine Vorderansicht eines bevorzugten Ausführungsbeispiels eines Rastelements in einer neutralen Position;
- Fig. 2: eine Seitenansicht des Rastelements gemäß Fig. 1, und
- Fig.3: eine schematische Schnittdarstellung einer vorgeschlagenen Verrastungsanordnung, wobei sich das Rastelement in einer aktiven Position befindet, die eine Sperrwirkung entfaltet.

In den Figuren werden gleiche Elemente jeweils mit den gleichen Bezugszeichen versehen.

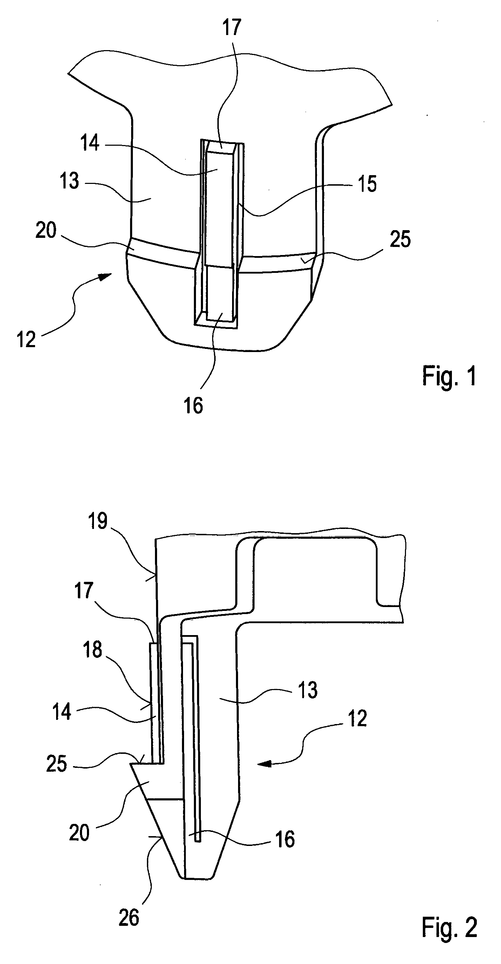

Fig. 1 zeigt eine Vorderansicht eines bevorzugten Ausführungsbeispiels eines Rastelements 12, das zur Verbindung eines nicht gezeigten ersten Körpers 10 mit einem zweiten Körper 11 vorgesehen ist. In Fig. 2 ist das Rastelement 12 in einer Seitenansicht dargestellt. Der erste Körper 10 ist insbesondere als Einbauteil eines Bodenstaubsaugers ausgebildet, der mit einem als Gehäuseteil ausgebildeten zweiten Körper 11 zu verbinden ist. Das Rastelement 12 weist eine Rastzunge 13 auf. In einem mittig angeordneten, längsgerichteten Durchbruch 15 der Rastzunge 13 ist ein Widerhaken 14 vorgesehen, der verschwenkbar an der Rastzunge 13 angelenkt ist. Mit seinem ersten Ende 16 ist der Widerhaken 14 fest mit der Rastzunge 13 verbunden, und mit seinem gegenüberliegenden zweiten Ende 17 ist der Widerhaken 14 bewegbar ausgebildet. In den Fig. 1 und 2 ist der Widerhaken 14 in einer neutralen Position dargestellt. Durch Krafteinwirkung von außen ist der Widerhaken 14 verschwenkbar. Der Widerhaken 14 steht mit seiner Außenfläche 18 zumindest bereichsweise über eine Oberfläche 19 der Rastzunge 13 über. Erfolgt nunmehr eine Krafteinwirkung von außen auf die überstehende Außenfläche 18 des Widerhakens 14, kann der Widerhaken 14 mit seinem zweiten Ende 17 nach innen geschwenkt werden.

Das erste Ende 16 des Widerhakens 14 ist in einem Bereich mit der Rastzunge 13 verbunden, in dem eine Rastnase 20 angeordnet ist. Die Rastnase 20 ist in der Art eines Vorsprungs ausgebildet, der über die Oberfläche 19 der Rastzunge 13 hervorragt. An seinem ersten Ende 16 weist der Widerhaken 14 einen geringeren Querschnitt auf als an seinem zweiten Ende 17. Der Widerhaken 14 ist aus einem elastischen Material gebildet und somit flexibel ausgestaltet, wodurch er leichter biegsam bzw. schwenkbar ist. Die Rastnase 20 und das zweite Ende 17 des Widerhakens 14 sind auf gegenüberliegenden Seiten des Rastelements 12 angeordnet. Die Rastnase 20 bildet eine ebene Auflagefläche 25 und verjüngt sich im Querschnitt keilförmig nach unten in Richtung zum ersten Ende 16 des Widerhakens 14, wodurch eine schräge Fläche 26 gebildet wird.

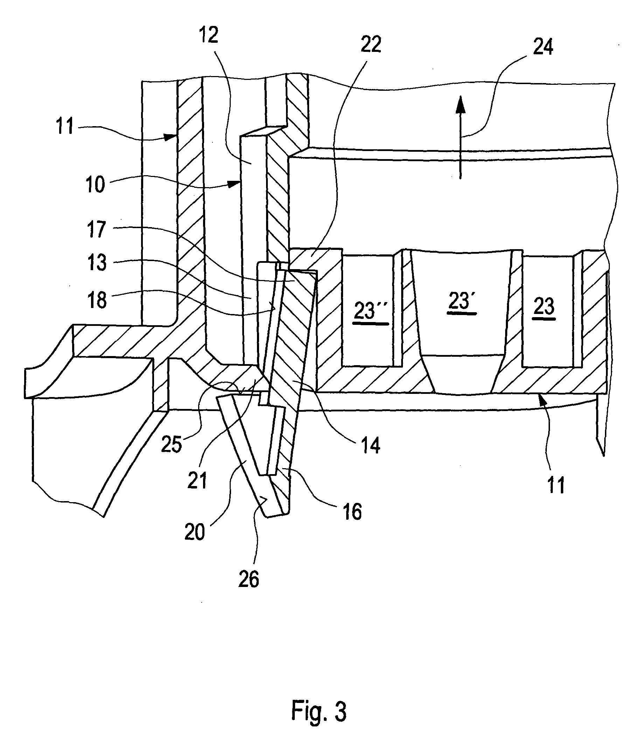

In Fig. 3 ist eine schematische Schnittdarstellung einer vorgeschlagenen Verrastungsanordnung dargestellt, wobei ein mit dem Rastelement 12 verbundener erster Körper 10, der als Einbauelement eines Staubsaugers ausgebildet ist, mit einem als Gehäuseteil ausgebildeten zweiten Körper 11 verrastet ist. Das Einbauelement 10 weist Gehäuseteile 23, 23', 23" für elektronische Komponenten bzw. Bedien- und Schaltelemente des Staubsaugers auf, die im Einzelnen nicht dargestellt sind. Von diesen Komponenten werden Missbrauchkräfte entlang einer Richtung 24 ausgelöst.

Fig. 3 zeigt das Einbauelement 10 in einer montierten Stellung mit dem Gehäuseteil 11, wobei beide Körper 11, 12 in einer Schließstellung selbsttätig versperrt sind. Dabei wirkt einerseits die Rastnase 20 des Rastelements 12 mit einem am Gehäuseteil 11 ausgebildeten Gegenrastelement 21 zusammen, und andererseits ist der Widerhaken 14 mit seinem zweiten Ende 17 mit einem korrespondierenden Element 22 des Gehäuseteils 11 verrastet.

Bei einer Montage des Einbauelements 10 mit dem Gehäuseteil 11 wird das Einbauelement 10 in einer definierten Stellung entlang einer Montagerichtung, welche gegen die Richtung 24 gerichtet ist, so mit dem Gehäuseteil 11 verbunden, dass das Gegenrastelement 21 entlang der rampenartig ausgebildeten schrägen Fläche 26 des Rastelements 12 geführt wird, bis die Rastnase 20 durch die Relativbewegung zwischen Einbauelement 10 und Gehäuseteil 12 durch Krafteinwirkung über den Widerstand des vorsprungartig ausgebildeten Gegenrastelements 21 geführt wird, bis die Rastnase 20 das Gegenrastelement 21 hintergreift und mit diesem verrastet. Das Gegenrastelement 21 wird dabei typischerweise durch eine Gehäusekante gebildet. Bei der Verrastung bildet die Rastnase 20 eine Auflagefläche 25 für das Gegenrastelement 21. Gleichzeitig wird der Widerhaken 14 mit seinem zweiten Ende 17 durch Krafteinwirkung des Gegenrastelements 21 von außen auf die Außenfläche 18 des Widerhakens 14 in das als Ausnehmung ausgebildete korrespondierende Element 22 des Gehäuseteils 11 gebogen und in dieser Position selbsttätig verklemmt. Der Widerhaken 14 entfaltet somit während des Montagevorgangs selbsttätig seine Sperrwirkung.

In seiner aktiven Position ist der Widerhaken 14 nach innen gebogen und befindet sich in einer gegenüber seiner Ausgangsposition schräg ausgerichteten Position. Ein Abstand zwischen dem Gegenrastelement 21 und dem korrespondierenden Element 22 des Gehäuseteils 11 ist dabei so dimensioniert, dass die Rastnase 20 mit dem Gegenrastelement 21 sowie der Widerhaken 14 des Rastelements 12 mit der Ausnehmung 22 spielfrei verrastet. Der Kraftaufwand, der zur Herstellung der Verrastung erforderlich ist, ist vorzugsweise so ausgelegt, dass eine Handmontage durchführbar ist. In der aktiven Position des Widerhakens 14 wird die Verrastungsanordnung gegen die Missbrauchskräfte stabilisiert. Gleichzeitig wird eine stabile Verbindung des Einbauteils 10 mit dem Gehäuseteil 11 hergestellt, die selbst unter großem Kraftaufwand von Hand nicht mehr lösbar ist. Günstigerweise weist das Einbauelement 10 wenigstens zwei, bevorzugt drei Rastelemente 12 auf, so dass eine stabile Verrastung mit dem Gehäuseteil 11 herstellbar ist.

Bezugszeichenliste
- 10: erster Körper
- 11: zweiter Körper
- 12: Rastelement
- 13: Rastzunge
- 14: Widerhaken
- 15: Durchbruch
- 16: Erstes Ende von 14
- 17: Zweites Ende von 14
- 18: Außenfläche von 14
- 19: Oberfläche von 13
- 20: Rastnase
- 21: Gegenrastelement
- 22: Element
- 23: 23', 23" Gehäuseteile
- 24: Richtung
- 25: Auflagefläche
- 26: Schräge Fläche von 20

## Patentansprüche

1. Rastelement zur Verbindung eines ersten Körpers (10) mit einem zweiten Körper (11), insbesondere eines Haushaltsgeräts, **dadurch gekennzeichnet, dass** rastelementseitig eine Rastzunge (13) mit einem Widerhaken (14) vorgesehen ist, wobei der Widerhaken (14) verschwenkbar an der Rastzunge (13) angelenkt ist, wobei ein erstes Ende (16) des Widerhakens (14) in einem Bereich mit der Rastzunge (13) verbunden ist, in dem eine Rastnase (20) ausgebildet ist, wobei der Widerhaken (14) mit einer Außenfläche (18) zumindest bereichsweise über eine Oberfläche (19) der Rastzunge (13) übersteht, wobei die Rastnase (20) an der Oberfläche (19) ausgebildet ist, so dass der Widerhaken (14) über Krafteinwirkung auf seine überstehende Außenfläche (18) mit einem zweiten Ende (17) auf die der Rastnase (20) gegenüberliegende Seite der Rastzunge (13) schwenkbar ist.

2. Rastelement nach Anspruch 1, **dadurch gekennzeichnet, dass** der Widerhaken (14) in einem längsgerichteten Durchbruch (15) der Rastzunge (13) angeordnet ist.

3. Rastelement nach Anspruch 1 oder 2, **dadurch gekennzeichnet, dass** der Widerhaken (14) mit seinem ersten Ende (16) fest mit der Rastzunge (13) verbunden und mit seinem gegenüberliegenden zweiten Ende (17) bewegbar ist.

4. Rastelement nach einem der vorhergehenden Ansprüche, **dadurch gekennzeichnet, dass** der Widerhaken (14) an seinem ersten Ende (16) einen geringeren Querschnitt aufweist als an seinem zweiten Ende (17).

5. Rastelement nach einem der vorhergehenden Ansprüche, **dadurch gekennzeichnet, dass** der Widerhaken (14) aus einem elastischen Material gebildet ist.

6. Verrastungsanordnung mit einem Rastelement (12) nach einem der Ansprüche 1 bis 5, mit einem mit dem Rastelement (12) verbundenen ersten Körper (10) sowie mit einem zweiten Körper (11), **dadurch gekennzeichnet, dass** das Rastelement (12) zusammen mit dem ersten Körper (10) in einer montierten Stellung mit dem zweiten Körper (11) so in einer Schließstellung selbsttätig versperrbar ist, dass die Rastnase (20) des Rastelements (12) mit einem am zweiten Körper (11) ausgebildeten Gegenrastelement (21) zusammenwirkt und der Widerhaken (14) mit einem freien Ende (17) mit einem korrespondierenden Element (22) des zweiten Körpers (11) verrastet ist.

7. Verrastungsanordnung nach Anspruch 6, **dadurch gekennzeichnet, dass** das korrespondierende Element (22) des zweiten Körpers (11) als Vertiefung ausgebildet ist, in welche der Widerhaken (14) mit seinem zweiten Ende (17) eingreift.

8. Verrastungsanordnung nach einem der Ansprüche 6 oder 7, **dadurch gekennzeichnet, dass** der Widerhaken (14) mit seinem zweiten Ende (17) während des Montagevorgangs durch Krafteinwirkung des Gegenrastelements (21) in das korrespondierende Element (22) des zweiten Körpers (11) verklemmbar ist.

## Claims

1. Catch element for connecting a first body (10) to a second body (11), in particular of a household appliance, **characterised in that** a latching tongue (13) with a barbed hook (14) is provided on the catch element side, the barbed hook (14) being hinged pivotably to the latching tongue (13), a first end (16) of the barbed hook (14) being connected to the latching tongue (13) in a region in which a latching nose (20) is configured, an outer surface (18) of the barbed hook (14) projecting at least partially beyond a surface (19) of the latching tongue (13), the latching nose (20) being configured on the surface (19) such that a second end (17) of the barbed hook (14) can be pivoted onto the side of the latching tongue (13) opposite the latching nose (20) by the action of a force on its projecting outer surface (18).

2. Catch element according to claim 1, **characterised in that** the barbed hook (14) is disposed in a longitudinally oriented aperture (15) in the latching tongue (13).

3. Catch element according to claim 1 or 2, **characterised in that** the first end (16) of the barbed hook (14) is connected in a fixed manner to the latching tongue (13) and its opposing second end (17) can be moved.

4. Catch element according to one of the preceding claims, **characterised in that** the barbed hook (14) has a smaller cross section at its first end (16) than at its second end (17).

5. Catch element according to one of the preceding claims, **characterised in that** the barbed hook (14) is made from an elastic material.

6. Latching arrangement having a catch element (12) as claimed in one of claims 1 to 5, with a first body (10) connected to the catch element (12) and with a second body (11), **characterised in that** in an assembled position with the second body (11) the catch element (12) together with the first body (10) can be locked automatically in a closed position such that the latching nose (20) of the catch element (12) interacts with a counter catch element (21) configured on the second body (11) and a free end (17) of the barbed hook (14) is latched to a corresponding element (22) of the second body (11).

7. Latching arrangement according to claim 6, **characterised in that** the corresponding element (22) of the second body (11) is configured as a depression, in which the second end (17) of the barbed hook (14) engages.

8. Latching arrangement according to one of claims 6 or 7, **characterised in that** the second end (17) of the barbed hook (14) can be clamped into the corresponding element (22) of the second body (11) by the action of a force from the counter catch element (21) during the assembly process.

## Revendications

1. Elément d'encliquetage destiné à relier un premier corps (10) à un deuxième corps (11), notamment d'un appareil ménager, **caractérisé en ce qu'**une languette d'encliquetage (13) munie d'un ardillon est ménagée côté élément d'encliquetage, l'ardillon (14) étant articulé de manière pivotante sur la languette d'encliquetage (13), une première extrémité (16) de l'ardillon (14) étant reliée à la languette d'encliquetage (13) dans une zone dans laquelle est réalisé un ergot d'encliquetage (20), l'ardillon (14) dépassant avec une surface extérieure (18) au moins en partie au-delà d'une surface (19) de la languette d'encliquetage (13), l'ergot d'encliquetage (20) étant réalisé sur la surface (19), de sorte que l'ardillon (14) est pivotant avec une deuxième extrémité (17) sur le côté de la languette d'encliquetage (13), opposé à l'ergot d'encliquetage (20), par l'intermédiaire de forces agissant sur sa surface extérieure (18).

2. Elément d'encliquetage selon la revendication 1, **caractérisé en ce que** l'ardillon (14) est disposé dans une ouverture (15) orientée en longueur de la languette d'encliquetage (13).

3. Elément d'encliquetage selon la revendication 1 ou 2, **caractérisé en ce que** l'ardillon (14) est relié de manière fixe à la languette d'encliquetage (13) avec sa première extrémité (16) et est déplaçable avec sa deuxième extrémité (17) située à l'opposé.

4. Elément d'encliquetage selon l'une quelconque des revendications précédentes, **caractérisé en ce que** l'ardillon (14) présente sur sa première extrémité (16) une section plus petite que sur sa deuxième extrémité (17).

5. Elément d'encliquetage selon l'une quelconque des revendications précédentes, **caractérisé en ce que** l'ardillon (14) est réalisé dans un matériau élastique.

6. Dispositif d'encliquetage muni d'un élément d'encliquetage (12) selon l'une quelconque des revendications 1 à 5, comprenant un premier corps (10) relié à l'élément d'encliquetage (12) ainsi qu'un deuxième corps (11), **caractérisé en ce que** l'élément d'encliquetage (12), en coopération avec le premier corps (10), peut être fermé automatiquement, dans une position montée avec le deuxième corps (11), de manière à ce que l'ergot d'encliquetage (20) de l'élément d'encliquetage (12) coopère avec un contre-élément d'encliquetage (21) réalisé sur le deuxième corps (11) et que l'ardillon (14), avec une extrémité libre (17), soit enclenché avec un élément correspondant (22) du deuxième corps (11).

7. Dispositif d'enclenchement selon la revendication 6, **caractérisé en ce que** l'élément correspondant (22) du deuxième corps (11) est réalisé comme approfondissement, dans lequel l'ardillon (14) a prise avec sa deuxième extrémité (17).

8. Dispositif d'enclenchement selon l'une quelconque des revendications 6 ou 7, **caractérisé en ce que** l'ardillon (14), avec sa deuxième extrémité (17), peut être serré dans l'élément correspondant (22) du deuxième corps (11) pendant l'opération de montage en raison de forces exercées par le contre-élément d'encliquetage (21).
